(19) Europäisches Patentamt
European Patent Office
Office européen des brevets

(11) **EP 2 946 938 B1**

(12) **EUROPÄISCHE PATENTSCHRIFT**

(45) Veröffentlichungstag und Bekanntmachung des Hinweises auf die Patenterteilung:
**12.04.2017 Patentblatt 2017/15**

(51) Int Cl.:
**B41M 5/24** (2006.01)   **B41M 5/28** (2006.01)

(21) Anmeldenummer: **15001405.8**

(22) Anmeldetag: **08.05.2015**

(54) **VERFAHREN ZUR LASERBEHANDLUNG VON BESCHICHTUNGEN**

METHOD FOR THE LASER TREATMENT OF COATINGS

PROCÉDÉ DE TRAITEMENT LASER DE REVÊTEMENTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.05.2014 EP 14001813**

(43) Veröffentlichungstag der Anmeldung:
**25.11.2015 Patentblatt 2015/48**

(73) Patentinhaber: **Merck Patent GmbH**
**64293 Darmstadt (DE)**

(72) Erfinder:
• **Quenzer, Matthias**
  **64686 Lautertal (DE)**
• **Klein, Sylke**
  **64380 Rossdorf (DE)**

(56) Entgegenhaltungen:
**EP-A2- 1 279 517      EP-A2- 1 661 729**
**WO-A2-2004/045857**

## Beschreibung

Die vorliegende Erfindung betrifft ein Verfahren zur Laserbehandlung von Beschichtungen, die Effektpigmente enthalten, damit hergestellte Beschichtungen sowie deren Verwendung in Dekorations- und Sicherheitsprodukten.

Der Einsatz von Laserstrahlung zur Behandlung von Kunststoffen ist seit langem bekannt und hat Anwendung in verschiedenen Bereichen gefunden, z. B. zur Markierung oder zum Verschweißen. Unter Lasermarkierung versteht man dabei das Markieren oder Beschriften von Kunststoffen und Lackoberflächen mit Hilfe eines intensiven Laserstrahls. Aus der Literatur sind Verfahren zur Laserbeschriftung von Schichtsystemen bekannt, die auf Phänomenen wie dem Aufschäumen bzw. Karbonisieren der Polymermatrix des Schichtsystems, dem Karbonisieren/ Dunkelfärben des Laseradditives (EP 1 215 233 B), Ausbleichen von Effektpigmenten (WO 2011/107271) und dem Farbumschlag lasersensitiver thermo- oder photochromer Additive beruhen.

Außerdem lassen sich Lasermarkierungen in einem Lackschichtsystem durch Ablation der oberen Lackschicht erzeugen. Die Ablation kann durch Laserlicht-absorbierende oder -reflektierende Additive hervorgerufen werden, die sich in der Lackschicht selbst oder in einer unter der Lackschicht aufgebrachten Opferschicht befinden (T. Schauer, R. Maurer, H. Greisiger, Kunstoffe 9 (2008), S 102-107).

WO2004/045857 offenbart ein Verfahren zur Änderung der optischen Eigenschaften einer Effektpigment-haltigen Beschichtung umfassend das Bestrahlen einer Beschichtung enthaltend ein Effektpigment, ein Bindemittel und eine IR-Strahlung absorbierende Komponente mit einem IR-Laser. Durch die Einwirkung der Laserstrahlung wird die Effektpigment-haltige Beschichtung aus den bestrahlten Bereichen der Beschichtung entfernt. Dreidimensionale Bilder und Motive lassen sich in Effektpigment-haltigen Schichten durch Veränderungen in der räumlichen Orientierung der Effektpigmente in der Schicht erzeugen, wie z.B. durch Verprägen

(US 4,675,212 und GB 2 272 848 A), magnetische Ausrichtung

(US 7,047,883 und EP 428 933 B1) oder durch das sogenannte Kiss-Printing Verfahren (WO 2012/079674).

Es besteht aber weiterhin Bedarf an Verfahren zur Beeinflussung von Lackeigenschaften, insbesondere zum Aufbringen von gut sichtbaren und kontrastreichen Mustern in Pigment-haltigen Beschichtungen.

Überraschenderweise wurde nun ein neues Verfahren gefunden, mit dem die optischen Eigenschaften von Effektpigment-haltigen Beschichtungen beeinflusst werden können und das sich insbesondere zur Aufbringung von Mustern oder Markierungen, z. B. als Sicherheitsmerkmal, eignet.

Gegenstand der Erfindung ist ein Verfahren zur Änderung der optischen Eigenschaften einer Effektpigment-haltigen Beschichtung umfassend das Bestrahlen einer Beschichtung (A) enthaltend mindestens ein Effektpigment, mindestens ein Bindemittel und mindestens eine IR-Strahlung absorbierende Komponente mit einem IR-Laser, wobei durch die Einwirkung der Laserstrahlung die IR-Strahlung absorbierende Komponente teilweise oder vollständig aus den bestrahlten Bereichen der Beschichtung (A) entfernt wird und das Effektpigment teilweise oder vollständig freigelegt wird und das Effektpigment ein Perlglanzpigment, ein Interferenzpigment, ein Metalleffektpigment und/oder ein Flüssigkristallpigment ist.

Freigelegt im Sinne der vorliegenden Erfindung bedeutet, dass das Effektpigment nicht oder nur teilweise mit der IR-Strahlung absorbierenden Komponente bedeckt oder belegt ist.

Weitere Gegenstände der Erfindung sind Beschichtungen enthaltend optische Muster, bevorzugt erhältlich mit dem neuen Verfahren, Produkte enthaltend solche Beschichtungen sowie deren Verwendung in Dekorations- und Sicherheitsprodukten.

Mit dem erfindungsgemäßen Verfahren ist es möglich, die optischen Eigenschaften einer Beschichtung zu verändern. Das Verfahren kann großflächig angewandt werden, um den Glanz oder Sparkle einer Beschichtung zu verändern, oder bildmäßig um optische Muster zu erzeugen.

Mit dem neuen Verfahren kann bevorzugt ein Produkt zur Verfügung gestellt werden, welches auf einer Oberfläche, die aus vielfältigen Materialien bestehen kann, eine Beschichtung aufweist, die ihrerseits ein Muster wie z. B. Bilder, Markierungen, Beschriftungen, etc. aufweist. Insbesondere können mit der Erfindung kontrastreiche, bevorzugt dreidimensionale, Muster erzeugt werden.

Mit dem Verfahren können zudem permanente und abriebfeste Muster erzeugt werden. Überraschenderweise wurde gefunden, dass mit dem neuen Verfahren das Bindemittel der Beschichtung bevorzugt nicht carbonisiert wird.

Ein Vorteil der Erfindung ist, dass die optischen Eigenschaften einer Beschichtung verändert werden können, ohne dass die Effektpigmente selbst verändert werden. Außerdem wird die räumliche Orientierung der Effektpigmente und/oder die Rauheit der beschichteten Oberfläche dabei bevorzugt nicht oder zumindest nicht wesentlich verändert.

Vorteilhafterweise kann mit der Erfindung ein gut sichtbares und kontrastreiches, aber nicht taktil erfassbares, bevorzugt dreidimensional erscheinendes, Muster erzeugt werden. Insbesondere kann damit eine sehr fein graduierte Kontrast- und Effektänderung innerhalb der gelaserten Schichtbereiche ermöglicht werden ohne die Effektpigmente zu schädigen. Diese fein graduierten Kontraste und Halbtöne ermöglichen bei entsprechenden Lasereinstellungen sogar Bilder in Fotoqualität.

Es ist ein besonderer Vorteil der vorliegenden Erfindung, dass mit dem erfindungsgemäßen Verfahren eine Möglichkeit zur Erzeugung von, bevorzugt dreidimensionalen, Mustern in Beschichtungen zur Verfügung steht, welches ohne größeren zusätzlichen apparativen und technischen Aufwand für die Erzeugung von, ggf. dreidimensionalen, Mustern in Beschichtungen eingesetzt werden kann, die Effektpigmente enthalten.

Insbesondere können mit dem, bevorzugt computergestützten, Laserverfahren beliebige Muster in frei wählbarer Reihenfolge und Häufigkeit bis hin zur individualisierten Kennzeichnung pro Einzelprodukt ohne aufwändige Rüstzeiten erzeugt werden. Das erfindungsgemäße Laserverfahren kann aber auch großflächig angewandt werden. Die schnelle und reproduzierbare Herstellung von dekorativen Massenartikeln oder Sicherheitsdokumenten ist daher mittels des erfindungsgemäßen Verfahrens auf einfache und kostengünstige Weise möglich. Auch in dünnen Schichten wie Beschichtungen, Lacken und Drucken sind Markierungen möglich ohne die Schichten signifikant zu schädigen.

Das erfindungsgemäße Verfahren zur Änderung der optischen Eigenschaften einer Pigmente enthaltenden Beschichtung umfasst bevorzugt die Schritte:

a) Aufbringen einer Beschichtung (A) enthaltend mindestens ein Effektpigment, mindestens ein Bindemittel und mindestens eine IR-Strahlung absorbierende Komponente auf ein Substrat, wobei das Effektpigment ein Perlglanzpigment, ein Interferenzpigment, ein Metalleffektpigment und/oder ein Flüssigkristallpigment ist,
b) Bestrahlen der in Schritt a) aufgebrachten Beschichtung (A) mit einem IR-Laser, wobei durch die Einwirkung von Laserlicht die IR-Strahlung absorbierende Komponente teilweise oder vollständig ausbleicht, oxidiert und/oder verdrängt wird,
c) ggf. Aufbringen einer Schutzschicht (B) auf der gemäß Schritt b) behandelten Beschichtung (A).

Dabei wird ein übliches Substrat, wie es weiter unten näher beschrieben wird, zunächst mit einer das Effektpigment und die IR-Strahlung absorbierende Komponente enthaltenden Beschichtung versehen und diese ggf. entsprechend abgelüftet und/oder ggf. getrocknet und ggf. ausgehärtet, eingebrannt oder vernetzt. Ggf. können die Beschichtung (A) und die Schutzschicht (B) gleichzeitig verfestigt werden.

Dann wird das, ggf. dreidimensionale, Muster in die Beschichtung gelasert, was gemäß den gewählten Laserparametern zur teilweisen oder völligen Bleichung, Oxidation und/oder Verdrängung der IR-Strahlung absorbierenden Komponente in der Beschichtung führt. Dadurch wird das Effektpigment teilweise oder völlig freigelegt, d.h. es ist nicht oder nur teilweise mit der IR-Strahlung absorbierenden Komponente bedeckt oder belegt.

In den gelaserten Bereichen können die im Kontrast entsprechend optisch veränderte Umgebung um die Effektpigmente herum, wie z.B. graduell hellere Hintergründe, und/oder die Reflexion von nicht planparallel zur Schichtoberfläche orientierten Effektpigmenten die erzeugten Muster dreidimensional erscheinen lassen, was sich bei der Betrachtung in verschiedenen Beobachtungswinkeln noch verstärkt. Dabei wird die Oberflächenrauheit der Beschichtung selbst nicht verändert.

Die Energie des Laserstrahls und die Eigenschaften der Effektpigment-haltigen Beschichtung werden dabei so abgestimmt, dass die IR-Strahlung absorbierende Komponente teilweise oder vollständig entfernt, bevorzugt verdrängt, oxidiert und/oder ausgebleicht wird. Das Effektpigment wird dadurch freigelegt, ohne dass das Effektpigment selbst oder seine räumliche Orientierung in der Beschichtung verändert wird.

IR-Laser mit einer Wellenlänge von 0,6 - 50 $\mu$m können verwendet werden. Bevorzugt verwendbar sind IR-Laser im nahen Infrarot-Bereich (0,65 - 10,6 $\mu$m), z.B. mit der Wellenlänge 1064 nm. Bevorzugt werden die Laser im gepulsten Modus betrieben, insbesondere bei Pulsfrequenzen von 40-100 kHz. Bevorzugt beträgt die Leistung des Lasers > 20%, insbesondere 30-50%. Die Geschwindigkeit kann 200-6000 mm/s betragen. Es können die üblichen, am Markt verfügbaren Geräte eingesetzt werden, bevorzugt Nd:YAG-Laser und $YVO_4$-Laser.

Eine wesentliche Komponente der Erfindung ist eine Beschichtung (A), die mindestens ein Effektpigment, mindestens ein Bindemittel und mindestens eine IR-Strahlung absorbierende Komponente enthält, wobei das Effektpigment ein Perlglanzpigment, ein Interferenzpigment, ein Metalleffektpigment und/oder ein Flüssigkristallpigment ist. Diese Komponente wird beim Lasern teilweise oder völlig entfernt. Bevorzugt wird die IR-Strahlung absorbierende Komponente durch die Einwirkung der Laserstrahlung teilweise oder vollständig aus den bestrahlten Bereichen der Beschichtung (A) verdrängt und das Effektpigment teilweise oder vollständig freigelegt. Es ist auch möglich, dass die IR-Strahlung absorbierende Komponente durch die Einwirkung der Laserstrahlung teilweise oder vollständig ausbleicht und/oder oxidiert. Dies kann zusätzlich zu oder anstatt der Verdrängung der IR-Strahlung absorbierende Komponente geschehen.

Dabei wird ein, ggf. dreidimensionales, Muster in der Beschichtung durch die teilweise oder gänzliche Entfernung der IR-absorbierenden Komponente erzeugt, bevorzugt durch Verdrängung, ggf. zusätzlich oder auch ausschließlich durch Bleichung und/oder Oxidation, und über die optischen Effekte der Effektpigmente sichtbar gemacht. Das Bild der, ggf. dreidimensionalen, Muster ist dabei sehr deutlich und kontrastreich ausgeprägt und kann bei entsprechenden Einstellungen Fotoqualitäten erreichen, ohne dass die Effektpigmente eine Auslenkung aus ihrer vorliegenden ursprünglichen Lage erfahren.

Für den Erfolg der vorliegenden Erfindung sind die einzelnen Farb- und/oder Glanzeffekte, die durch die Effektpigmente erzielt werden können, an sich nicht ausschlaggebend. Vielmehr wird der erfindungsgemäße Erfolg durch die Veränderung des optisch wahrnehmbaren Effektes der, bevorzugt plättchenförmigen, Effektpigmente an den Stellen der Beschichtung erzielt, die gelasert und damit in ihrem Umgebungskontrast durch verschiedene Helligkeitsabstufungen verändert wurden.

Durch das Entfernen der IR-Strahlung absorbierenden Komponente durch Verdrängen, Ausbleichen und/oder Oxidieren können außerdem auch Effektpigmente zur Reflexion beitragen, die nicht planparallel zur Schichtoberfläche liegen, d.h. nicht im Glanzwinkel reflektieren, aber bei flachen Beobachtungswinkeln nun in Reflexionsstellung kommen und dadurch einen dreidimensionalen Eindruck vermitteln können.

Somit werden in den gelaserten Schichtbereichen die optische Effekte der Effektpigmente verstärkt, wobei je nach Teilchengröße und Art der eingesetzten Effektpigmente Effekte wie Perlglanz, Sparkling (Glitzer) und/oder Schimmer wesentlich verstärkt und/ oder die Effektfarbe verändert werden, was den dreidimensionalen Eindruck verstärkt, ohne dass sich die Effektpigmente selbst oder deren vorliegende räumliche Orientierung in der Schicht verändert. Bevorzugt können durch die Einwirkung der Laserstrahlung Perlglanz, Sparkling (Glitzer) und/oder Schimmer der Beschichtung (A) verstärkt werden.

Messbar ist dies in der Erhöhung der L-Werte bzw. in der Erhöhung der Sparkling Intensity $S_i$ und der Sparkling Area $S_a$ in den gelaserten Bereichen.

Im Allgemeinen ist der Sparkling (Glitzer)-Effekt nur unter direkter Sonneneinstrahlung wahrnehmbar und abhängig vom Beobachtungswinkel. Die messtechnische Erfassung des Sparkling Effekts erfolgt daher unter der Beleuchtung der Messprobe mit sehr hellen LEDs und unter drei verschiedenen Beleuchtungswinkeln (15°, 45° und 75°) mit dem Gerät Bykmac i. Senkrecht zur Messprobe nimmt eine hochauflösenden CCD-Kamera jeweils ein Bild auf. Die glitzernden Pigmente werden hier als helle Punkte sichtbar, in den jeweiligen Helligkeitsstufen (= Sparkling Intensity Si) und in ihrer Fläche (Sparkling Area $S_a$) erfasst und mit Bildverarbeitungs-Software analysiert. Die Bewertung des Sparkling Effekts erfolgt durch den Vergleich der Messprobe mit einem festgelegten Standard. Daher sind die Messwerte als Δ-Werte erfasst (BYK-Gardner Digital Katalog 2013 D "Das objektive Auge", Nr. 1309 225 015 710, Seite 97).

Werden die gelaserten Beschichtungen coloristisch bewertet, so zeigen sie generell höhere L-Werte als die ungelaserten Bereiche, da die IR-Strahlung absorbierende Komponente durch die Lasereinwirkung verdrängt, ausgeblichen und/oder oxidiert wurde. Bei der Verwendung eines Effektpigments mit Sparkling-Effekt wie die Xirallic®-Typen werden zudem die Sparkling Intensity $S_i$ und Sparkling Area $S_a$ ebenfalls erhöht. Insbesondere zeigt sich eine stärker wachsende positive Differenz je flacher der Beobachtungswinkel wird. Das heißt, es kommen im gelaserten Bereich auch die Effektpigmente zu Reflexion, die nicht planparallel zur Schichtoberfläche liegen, aber durch die Lasereinwirkung freigelegt wurden.

Als Effektpigmente werden entsprechend der Erfindung Perlglanzpigmente, Interferenzpigmente, Metalleffektpigmente und/oder Flüssigkristallpigmente verwendet. Bevorzugt werden Effektpigmente mit einem plättchenförmigen Träger verwendet, welcher optional mindestens eine Beschichtung aus einem Metalloxid, Metalloxidhydrat oder deren Gemischen, einem Metallmischoxid, -suboxid, -oxinitrid, Metallfluorid oder einem Polymer umfasst. Perlglanzpigmente bestehen aus transparenten Plättchen mit hoher Brechzahl und zeigen bei paralleler Orientierung durch Mehrfachreflexion einen charakteristischen Perlglanz. Solche Perlglanzpigmente, die zusätzlich auch Interferenzfarben zeigen, werden als Interferenzpigmente bezeichnet.

Obwohl natürlich auch klassische Perlglanzpigmente wie $TiO_2$-Plättchen, basisches Bleicarbonat, BiOCl-Pigmente oder Fischsilberpigmente prinzipiell geeignet sind, werden als Effektpigmente im Sinne der Erfindung vorzugsweise plättchenförmige Interferenzpigmente oder Metalleffektpigmente eingesetzt, welche auf einem plättchenförmigen Träger mindestens eine Beschichtung aus einem Metalloxid, Metalloxidhydrat oder deren Gemischen, einem Metallmischoxid, Metallsuboxid, Metalloxinitrid, Metallfluorid oder einem Polymer aufweisen.

Der plättchenförmige Träger besteht vorzugsweise aus natürlichem oder synthetischem Glimmer, Kaolin oder einem anderen Schichtsilikat, aus Glas, Calcium-Aluminium-Borosilikat, $SiO_2$, $TiO_2$, $Al_2O_3$, $Fe_2O_3$, Polymerplättchen. Besonders bevorzugt sind plättchenförmige Träger aus Glimmer, Glas, Calcium-Aluminium-Borosilikat, Graphit, $SiO_2$, $Al_2O_3$.

Die Größe des plättchenförmigen Trägers ist an sich nicht kritisch. Die Träger weisen in der Regel eine Dicke zwischen 0,01 und 5 μm, insbesondere zwischen 0,05 und 4,5 μm und besonders bevorzugt von 0,1 bis 1 μm auf. Die Ausdehnung in der Länge bzw. Breite beträgt üblicherweise von 1 bis 500 μm, vorzugsweise von 1 bis 200 μm und insbesondere von 5 bis 125 μm. Sie besitzen in der Regel ein Aspektverhältnis (Verhältnis des mittleren Durchmessers zur mittleren Teilchendicke) von 2:1 bis 25000:1, vorzugsweise von 3:1 bis 1000:1 und insbesondere von 6:1 bis 250:1.

Die genannten Maße für die plättchenförmigen Träger gelten prinzipiell auch für die erfindungsgemäß verwendeten beschichteten Effektpigmente, da die zusätzlichen Beschichtungen in der Regel im Bereich von nur wenigen Hundert Nanometern liegen und damit die Dicke oder Länge bzw. Breite (Teilchengröße) der Pigmente nicht wesentlich beeinflussen. Bevorzugt besteht eine auf dem Träger aufgebrachte Beschichtung aus Metalloxiden, Metallmischoxiden, Metallsuboxiden oder Metallfluoriden und insbesondere aus einem farblosen oder farbigen Metalloxid, ausgewählt aus $TiO_2$, Titansuboxiden, Titanoxinitriden, $Fe_2O_3$, $Fe_3O_4$, $SnO_2$, $Sb_2O_3$, $SiO_2$, $Al_2O_3$, $ZrO_2$, $B_2O_3$, $Cr_2O_3$, ZnO, CuO, NiO

oder deren Gemischen.

Als Metallfluorid wird bevorzugt MgF$_2$ eingesetzt.

Besonders bevorzugt sind Effektpigmente, welche einen plättchenförmigen Träger aus natürlichem oder synthetischem Glimmer, Glas, Calcium-Aluminium-Borosilikat, SiO$_2$, Al$_2$O$_3$, und mindestens eine Beschichtung auf dem Träger aufweisen, welche aus TiO$_2$, Titansuboxiden, Titanoxinitriden, Fe$_2$O$_3$, Fe$_3$O$_4$, SnO$_2$, Sb$_2$O$_3$, SiO$_2$, Al$_2$O$_3$, MgF$_2$, ZrO$_2$, B$_2$O$_3$, Cr$_2$O$_3$, ZnO, CuO, NiO oder deren Gemischen ausgewählt ist. Insbesondere plättchenförmige Effektpigmente mit einem Träger aus natürlichem oder synthetischem Glimmer, SiO$_2$ oder Al$_2$O$_3$, sind geeignet. Bevorzugt können Substrate aus Al$_2$O$_3$ verwendet werden.

Die Effektpigmente können einen Mehrschichtaufbau aufweisen, bei dem sich auf einem nichtmetallischen Träger mehrere Schichten übereinander befinden, die vorzugsweise aus den vorab genannten Materialien bestehen und verschiedene Brechzahlen in der Art aufweisen, dass sich jeweils mindestens zwei Schichten unterschiedlicher Brechzahl abwechselnd auf dem Träger befinden, wobei sich die Brechzahlen in den einzelnen Schichten um wenigstens 0,1 und bevorzugt um wenigstens 0,3 voneinander unterscheiden. Dabei können die auf dem Träger befindlichen Schichten sowohl farblos als auch farbig, überwiegend transparent, semitransparent oder auch opak sein.

Je nach verwendetem Trägermaterial und Art der aufgebrachten Schichten sind damit auch die erhaltenen Effektpigmente farblos oder weisen eine Körperfarbe auf, bzw. sind überwiegend transparent, semitransparent oder opak. Durch das Ein- oder Mehrschichtsystem auf dem Träger sind sie aber zusätzlich in der Lage, mehr oder weniger intensive und glänzende Interferenzfarben zu erzeugen.

Ebenso können die sogenannten LCPs (Liquid Crystal Pigments), die aus vernetzten, orientierten, cholesterischen Flüssigkristallen bestehen, oder aber auch als holographische Pigmente bezeichnete Polymer- oder Metallplättchen als Effektpigmente eingesetzt werden.

Die vorab beschriebenen Effektpigmente können in den erfindungsgemäß eingesetzten Beschichtungen einzeln oder als Gemisch von zwei oder mehreren vorhanden sein. Ebenso können sie im Gemisch mit organischen und/oder anorganischen Farbstoffen oder Farbpigmenten und/oder auch in Gemischen mit unbeschichtetem Glimmer eingesetzt werden.

Dabei beträgt der Gewichtsanteil der Effektpigmente, bevorzugt der plättchenförmigen Effektpigmente, in der jeweiligen, bindemittelhaltigen Beschichtung im allgemeinen zwischen 1 und 35 Gewichtsprozent und vorzugsweise zwischen 3 und 30 Gewichtsprozent, bezogen auf die Partikelmassenkonzentration des trockenen Schichtsystems.

Als Effektpigmente können beispielsweise die im Handel erhältlichen funktionellen Pigmente, Interferenzpigmente oder Perlglanzpigmente, welche unter den Bezeichnungen Iriodin®, Colorstream®, Xirallic®, Miraval®, Ronastar®, Biflair®, Minatec®, Lustrepak®, Colorcrypt®, Colorcode® und Securalic® von der Firma Merck KGaA angeboten werden, Mearlin® der Firma Mearl sowie optisch variable Effektpigmente, Helicone® der Firma Wacker, holographische Pigmente der Firma Spectratec sowie andere kommerziell erhältliche Effektpigmente eingesetzt werden. Besonders bevorzugt sind Xirallic® Pigmente.

Als weiteren wesentlichen Bestandteil enthält die erfindungsgemäße Beschichtung (A) mindestens eine IR-absorbierende Komponente. IR-absorbierende Pigmente, insbesondere dunkle IR-absorbierende Pigmente, können bevorzugt eingesetzt werden. Nanoteilige Farbruße oder Phthalocyanine haben sich als besonders geeignet erwiesen und werden in vielen Farbrezepturen ohnehin schon als Farbpigmente eingesetzt. Anwendung finden z.B. die Farbruß-Typen der Rhône Capital LLC und die Hostaperm® Blue-Typen der Firma Clariant, die Heliogen® Blau-Typen der Fa. BASF u.a.

Dabei beträgt der Gewichtsanteil der IR-absorbierenden Komponente im Allgemeinen zwischen 0,1 und 10 Gewichtsprozent und vorzugsweise zwischen 0,2 und 5 Gewichtsprozent und insbesondere zwischen 0,5 und 3 Gewichtsprozent, bezogen auf die Partikelmassenkonzentration des trockenen Schichtsystems.

Die Beschichtungszusammensetzung für die Beschichtung (A) enthält neben den Effektpigmenten und der IR-Strahlung absorbierenden Komponente auch mindestens ein Bindemittel sowie optional mindestens ein Lösemittel und gegebenenfalls einen oder mehrere Hilfsstoffe.

Als Bindemittel kommen allgemein für Beschichtungszusammensetzungen übliche Bindemittel, insbesondere solche auf Nitrocellulosebasis, Polyamidbasis, Acrylbasis, Polyvinylbutyralbasis, PVC-Basis, PUR-Basis oder geeignete Gemische aus diesen, und insbesondere Bindemittel auf UV-härtbarer Basis (radikalisch oder kationisch härtend) in Betracht. Es liegt auf der Hand, dass für das erfindungsgemäße Verfahren bevorzugt Bindemittel für die Beschichtungszusammensetzungen ausgewählt werden, die nach dem Verfestigen der entsprechenden Schicht transparent sind, so dass die gebildeten, ggf. dreidimensionalen, Muster in der gelaserten Beschichtung (A) optisch gut erkennbar sind.

Sollte auf einer solchen Schicht eine Effektpigment-freie Schutzschicht (B) aufgebracht worden sein, enthält diese bevorzugt ein nach dem Verfestigen ebenfalls transparentes Bindemittel. Diese Schutzschicht wird durch die darunter liegende gelaserte Beschichtung (A) nicht verändert. Die entsprechenden Bindemittel sind dem Fachmann geläufig und können bevorzugt aus den o.g. Bindemitteln ausgewählt werden.

Des Weiteren enthält die Beschichtungszusammensetzung für die Beschichtung (A) und ggf. für die Schutzschicht (B) optional auch mindestens ein Lösemittel, welches aus Wasser und/oder organischen Lösemitteln oder aus organischen Lösemittelgemischen besteht.

Als organische Lösemittel können alle in den genannten Beschichtungsverfahren üblicherweise verwendeten Lösemittel, beispielsweise verzweigte oder unverzweigte Alkohole, Aromaten oder Alkylester, wie Ethanol, 1-Methoxy-Propanol, 1-Ethoxy-2-propanol, Ethylacetat, Butylacetat, Toluol, etc., oder deren Gemische verwendet werden.

Ebenso können der oder den Beschichtungszusammensetzungen allgemein gebräuchliche Additive wie Füllstoffe, weitere Farbpigmente oder Farbstoffe, UV-Stabilisatoren, Inhibitoren, Flammschutzmittel, Gleitmittel, Dispergiermittel, Redispergiermittel, Entschäumer, Verlaufsmittel, Filmbildner, Haftvermittler, Trocknungsbeschleuniger, Trocknungsverzögerer, Fotoinitiatoren etc. zugegeben werden.

Es versteht sich von selbst, dass die konkrete stoffliche Zusammensetzung der jeweiligen Beschichtungszusammensetzung und deren Viskosität von der Art der gewählten Beschichtungsverfahren und dem jeweiligen Beschichtungssubstrat abhängig sind. Dabei wird der Feststoffgehalt der Beschichtungszusammensetzung je nach verwendetem Verfahren, Beschichtungstemperatur, Beschichtungsgeschwindigkeit und Art der Bindemittel, Additive und Art des Substrats so eingestellt, dass die Viskosität der Beschichtungszusammensetzung ausreicht, um eine möglichst optimale Übertragung der Beschichtungszusammensetzung von der jeweiligen Beschichtungsapparatur auf dem Substrat bzw. auf die erste Schicht zu erzielen. Diese Einstellung der Viskosität erfolgt direkt an der Beschichtungsmaschine und kann ohne erfindungsgemäßes Zutun beruhend auf den Angaben des Herstellers der Beschichtungszusammensetzung oder dem Fachwissen des Druckers bzw. Beschichtungsexperten ausgeführt werden.

Das vorliegende Verfahren kann zur Herstellung von Markierungen auf allen Oberflächen, bevorzugt auf lackierten oder bedruckten Oberflächen, verwendet werden. Es kann sowohl für dekorative Zwecke eingesetzt werden als auch zur Herstellung von Sicherheitsmerkmalen dienen. Die mit dem Verfahren hergestellten Markierungen sind sowohl für Innen- wie auch für Außenbereiche geeignet. Es können z. B. Kennzeichnung, Codierung, Logos, Typenbezeichnung und andere individuelle Markierungen hergestellt werden. Das Verfahren eignet sich besonders auch zur Markierung von Lacken, insbesondere von Automobillacken und Industrielacken.

Als Substrate zur Herstellung der erfindungsgemäßen Beschichtung kommt eine Vielzahl von Substraten in Betracht, wie sie gewöhnlicherweise zur Herstellung verschiedenster dekorativer Produkte und Sicherheitsprodukte eingesetzt wird.

Dabei umfasst der Begriff dekoratives Produkt im Sinne der vorliegenden Erfindung einen breiten Bereich von Verpackungsmaterialien, Papeterieartikeln, Spezialpapieren, Textilmaterialien, Dekorationsmaterialien, Werbematerialien, Lehrmitteln, Scherzartikeln, Geschenkartikeln, Möbelbeschichtungsfolien oder -papieren, aber auch Materialien zur funktionellen Beschichtung und/oder künstlerischen Dekoration und Kennzeichnung von Gebäuden oder Gebäudeteilen, Fahrbahnen, Schildern, Fahr- und Flugzeugen, Kunstobjekten und dergleichen. Besonders bevorzugte erfindungsgemäße Produkte sind u.a. auch Automobile bzw. Automobilteile.

Als Sicherheitsprodukte im Sinne der vorliegenden Erfindung werden beispielsweise Etiketten, Eintrittskarten, Fahrausweise, Pässe, Ausweisdokumente, Banknoten, Schecks, Kreditkarten, Aktien, Briefmarken, Chipkarten, Führerscheine, Urkunden, Prüfbescheinigungen, Wertmarken, Steuerbanderolen, Fahrzeugkennzeichen, Mautgebühr-Aufkleber, TÜV-Plaketten, Feinstaub-Plaketten oder Siegel angesehen, um nur typische Produkte zu nennen.

Demzufolge bestehen die erfindungsgemäß verwendeten Substrate aus Materialien wie Papier, Kartonagen, Laminaten, Holz, Metallen, insbesondere Metallbleche und -folien, Polymeren, insbesondere polymeren Folien, Sicherheitsdruckerzeugnissen oder Materialien, welche Bestandteile aus mehreren dieser Stoffe enthalten. Wie bei Papieren, Polymerfolien und Metallsubstraten üblich, kann das Substrat optional auch noch elektrostatisch vorbehandelt und/oder mit einer Primerschicht und/oder einer anderen Grundierschicht versehen sein.

Selbstverständlich sind solche Substratmaterialien besonders bevorzugt, die üblicherweise mittels Lackier- oder Druckverfahren auch in großer Stückzahl und über kontinuierliche Verfahren beschichtet werden, also alle Sorten von Papieren und Kartonagen sowie Polymer- oder Metallfolien, Metallblechen und Verbundmaterialien aus zwei oder mehreren von diesen.

Als Auftragsverfahren für die Beschichtung (A) und auch für die Schutzschicht (B) stehen prinzipiell alle Verfahren zur Verfügung, die auf die bereits oben genannten Substrate üblicherweise angewendet werden wie z.B. Lackierungen durch Sprühen, Spritzen, Tauchen, Streichen, Rollen, elektrostatisches Zerstäuben (Pulverlackierung) und Coil Coating, Druckverfahren wie Tief-, Flexo, Sieb-, Offsetdruck sowie die Papierbeschichtungsverfahren der plättchenförmigen Effektpigmente. Das Aufbringen der Beschichtungszusammensetzung auf das Substrat kann, abhängig vom gewünschten Ergebnis, vollflächig oder teilflächig erfolgen.

Gegenstand der vorliegenden Erfindung ist auch eine Beschichtung auf einem Substrat enthaltend ein optisch sichtbares Muster, wobei die Beschichtung mindestens ein Effektpigment, mindestens ein Bindemittel und mindestens eine IR-Strahlung absorbierende Komponente enthält und die IR-Strahlung absorbierende Komponente in Teilbereichen des optischen Musters nicht vorhanden ist, und das Effektpigment in den bestrahlten Bereichen teilweise oder vollständig freigelegt ist, wobei das Effektpigment ein Perlglanzpigment, ein Interferenzpigment, ein Metalleffektpigment und/oder ein Flüssigkristallpigment ist.

Bevorzugt ist eine Beschichtung, in der die IR-Strahlung absorbierende Komponente in Teilbereichen des optischen Musters teilweise oder vollständig verdrängt, oxidiert und/oder ausbleicht ist.

Bevorzugt wird das optisch sichtbare Muster durch unterschiedlichen Perlglanz, Sparkling (Glitzer) und/oder Schimmer in den bestrahlten und nicht-bestrahlten Bereichen der Beschichtung (A) hervorgerufen wird. Insbesondere bevorzugt ist eine Beschichtung, deren optisches Muster taktil nicht erfassbar ist.

Gegenstand der vorliegenden Erfindung ist auch die Verwendung der erfindungsgemäßen Beschichtung als Dekorationselement, als Funktionselement oder als Sicherheitsmerkmal auf einem Produkt. Gegenstand der vorliegenden Erfindung ist auch ein Produkt, welches eine Oberfläche aufweist, die ein, bevorzugt dreidimensionales, Muster in einer Beschichtung (A) auf einem Substrat aus Papier, einer Kartonage, einem Laminat, Holz, einem Polymer, einem Metall, einer polymeren Folie, einer Metallfolie, einem Sicherheitsdruckerzeugnis oder aus einem Material aufweist, welches Bestandteile aus mehreren dieser Stoffe enthält, und wobei das Substrat optional elektrostatisch vorbehandelt und/oder mit einer Primerschicht und/oder einer anderen Grundierschicht versehen ist, und wobei die Beschichtung (A) optional zusätzlich eine Schutzschicht (B) aufweist, wobei die Beschichtung (A) mindestens ein Effektpigment, bevorzugt plättchenförmiges Effektpigment, und mindestens eine IR-Strahlung absorbierende Komponente enthält.

Solche Produkte sind nach dem vorab beschriebenen erfindungsgemäßen Verfahren erhältlich und weisen die oben näher beschriebenen, bevorzugt dreidimensionalen, Muster auf.

Gegenstand der vorliegenden Erfindung ist auch die Verwendung der gemäß dem erfindungsgemäßen Verfahren hergestellten Produkte als oder für Dekorationsmaterialien oder Sicherheitserzeugnisse. Einzelheiten hierzu sind vorab ebenfalls bereits beschrieben worden.

Es ist ein besonderer Vorteil der vorliegenden Erfindung, dass mit dem erfindungsgemäßen Verfahren ein Verfahren zur Erzeugung von dreidimensionalen Mustern in Beschichtungen zur Verfügung steht, welches ohne größeren zusätzlichen apparativen und technischen Aufwand für die Erzeugung von dreidimensionalen Mustern in Beschichtungen eingesetzt werden kann, die plättchenförmige Effektpigmente enthalten.

Mit dem computergestützten Laserverfahren können beliebige Muster in frei wählbarer Reihenfolge und Häufigkeit bis hin zur individualisierten Kennzeichnung pro Einzelprodukt ohne aufwändige Rüstzeiten erzeugt werden. Die schnelle und reproduzierbare Herstellung von dekorativen Massenartikeln oder Sicherheitsdokumenten ist daher mittels des erfindungsgemäßen Verfahrens auf einfache und kostengünstige Weise möglich.

In der Beschreibung und in den Beispielen sind Prozentangaben, soweit nicht anders angegeben, Gewichtsprozent. Alle verwendeten Verbindungen sind bekannt oder käuflich erhältlich. Die folgenden Beispiele erläutern die vorliegende Erfindung näher, ohne den Schutzbereich zu beschränken.

## Beispiele

### Beispiel 1:

Zur Herstellung eines Schichtsystems, das durch eine Spritzapplikation aufgetragen wird, wird ein konventionelles Refinish-Lacksystem mit folgender Rezeptur verwendet.

1. Effektpigment-haltiger Lack

| | |
|---|---|
| 2,64 Gew.% | Xirallic® Crystal Silver (Effektpigment, Fa. Merck KGaA) |
| 34,90 Gew.% | Standard Thinner XB 383 (Fa. DuPont) |
| 16,23 Gew.% | Centari 6000 XB 165 Basislack (Fa. DuPont) |
| 46,23 Gew.% | Basislack Tiefschwarz Mix 571 (Fa. Standox) |

2. Klarlack (optional)

| | |
|---|---|
| 90 Gew.% | 1 K-Hightec Clearcoat (Fa. PPG) |
| 10 Gew.% | Verdünner Solvesso 100 (Fa. Exxon Mobil Chemicals) |

Das Effektpigment wird zunächst vorgelegt und mit dem Verdünner angeschlämmt. Anschließend werden die Pigmentpasten und ggf. Bindemittel hinzugegeben und mit einem Flügelrührer homogenisiert. Durch Zugabe von Verdünner wird die spritzfertige Viskosität eingestellt und der Lack mit einem Spritzautomat der Fa. Oerter auf ein Blech lackiert.

Nach dem Ablüften der Lackschicht wird nun das gewünschte Muster mit den unten beschriebenen Laserparametern gelasert. Abschließend wird optional noch ein Klarlack als Schutzschicht appliziert und das Schichtsystem im Ofen bei 130°C für 30min vernetzt.

Es werden gut sichtbare und kontrastreiche Muster erhalten.

**Beispiel 2:**

Zur Herstellung eines Schichtsystems, das durch eine Spritzapplikation aufgetragen wird, können auch mehrere Effektpigmente oder Stylings von Effektpigment mit anderen Farbpigmenten im Lack angewandt werden.

Während in Beispiel 1 nur ein Effektpigment und Ruß als IR-absorbierendes Pigment eingesetzt sind, werden folgende Pigmentrezepturen mit mehreren Effektpigmenten und Phthalocyaninen beispielhaft getestet.

Pigmentrezeptur 1

| | |
|---|---|
| 10,9 Gew % | Colorstream® F20-00 WNT Autumn Mystery (Effektpigment, Fa. Merck KGaA) |
| 5,1 Gew.% | Xirallic® SW Crystal Silver (Effektpigment, Fa. Merck KGaA) |
| 1,3 Gew.% | $TiO_2$ Kronos 2310 (Fa. Kronos) |
| 0,7 Gew.% | Ruß FW 200 (Fa. Rhône) |

Pigmentrezeptur 2

| | |
|---|---|
| 10,8 Gew.% | Xirallic® SW Sunbeam Gold (Effektpigment, Fa. Merck KGaA) |
| 7,8 Gew.% | Monastral Grün 6Y spez. (Fa. Heubach) |
| 3,6 Gew.% | Heliogen Blau 7080 (Fa. BASF) |
| 1,2 Gew.% | Bayferrox 3920 FF (Fa. Lanxess) |
| 0,9 Gew.% | Ruß FW 200 (Fa. Rhône) |

Die Einarbeitung der Pigmente in den Lack sowie die Spritzlackierung und Laserung erfolgen analog Beispiel 1. Es werden gut sichtbare und kontrastreiche Muster erhalten.

**Beispiel 3:**

Zur Herstellung eines Schichtsystems, das durch eine Pulverlackierung aufgebracht wird, wird eine sogenannte Dry-Blend Mischung folgender Zusammensetzung hergestellt.

| | |
|---|---|
| 5 Gew.% | Iriodin® 9119 (Effektpigment, Fa. Merck KGaA) |
| 95 Gew.% | Alesta IP Black (Fa. DuPont) |

Dazu werden der Ruß-haltige Pulverlack und das Effektpigment in einem Kunststoffbehälter eingewogen und anschließend in einem Über-Kopf Mischer homogen gemischt.
Nach der Pulverlackierung erfolgt das Einbrennen des Pulverlacks bei 200 °C, 20 min. Anschließend erfolgt das Lasern des gewünschten Musters mit den unten beschriebenen Laserparametern. Es werden gut sichtbare und kontrastreiche Muster erhalten.

**Beispiel 4:**

Zur Herstellung eines Schichtsystems, das durch ein Druckverfahren aufgetragen wird, wird folgende Rezeptur für eine Siebdruckfarbe angewendet.

| | |
|---|---|
| 10 Gew.% | Xirallic® Crystal Silver (Effektpigment, Fa. Merck KGaA) |
| 5 Gew.% | Follmann FS 10-801 schwarz (Fa. Follmann) |
| 85 Gew.% | Follmann FS 10-931 wässrig (Fa. Follmann) |

Das Effektpigment wird in das Siebdruckbindemittel eingerührt und mit der schwarzen Einfärbepaste zu einer homogenen Siebdruckfarbe verarbeitet. Der Siebdruck erfolgt mit einem 61 T Sieb auf verschiedenen Substraten, wie beschichtete Papiere/ Fotopapiere wie auch auf unbeschichtete Papiere. Nach dem Lasern des gewünschten Musters mit den unten beschriebenen Laserparametern kann optional ein Überdruck mit einem UV-Lack erfolgen, z. B. mit dem UV-Binder Weilburger 363030. Es werden gut sichtbare und kontrastreiche Muster erhalten.

Folgende Laserparameter werden für einen IR-Festkörperlaser ($YVO_4$-Laser, Typ Vmc 5) der Fa. Trumpf mit der Wellenlänge 1064 nm und der mittleren Laserleistung von 12 W im gepulsten Modus verwendet.

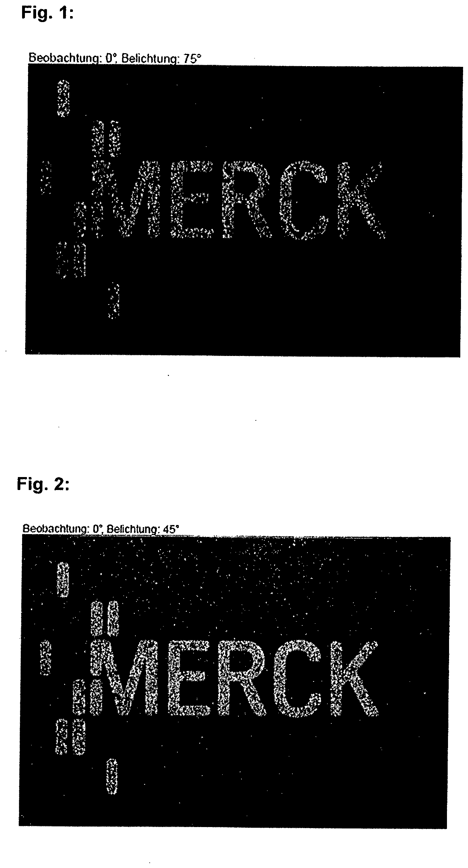

Laserparameter Schrift auf spritzlackierten Blechen (Abb. 1-3)

| | |
|---|---|
| Spurbreite: | 0,05mm |
| Leistung: | 35% |
| Geschwindigkeit: | 300 mm/s |
| Pulsfrequenz: | 80 kHz |

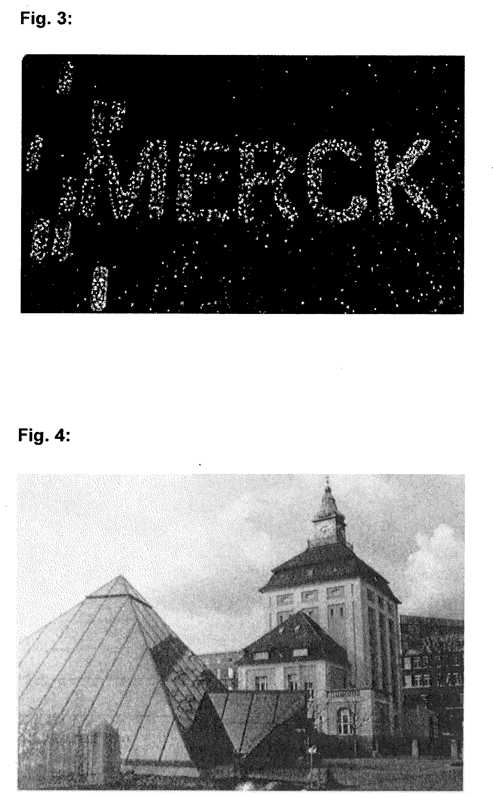

Laserparameter Bild auf spritzlackierten Blechen (Abb. 4)

| | |
|---|---|
| Auflösung: | 800dpi |
| Spurbreite: | 0,05mm |
| Leistung: | 33% |
| Geschwindigkeit: | 5000 mm/s |
| Pulsfrequenz: | 100 kHz |

Laserparameter Schrift auf Siebdrucken (Substrat: Fotopapier)

| | |
|---|---|
| Spurbreite: | 0,05mm |
| Leistung: | 40% |
| Geschwindigkeit: | 2500 mm/s |
| Pulsfrequenz: | 80 kHz |

Werden die gelaserten Muster aus Abb. 1-3 coloristisch bewertet, so zeigen sie generell höhere L-Werte als die ungelaserten Bereiche, da das dunkle IR-Absorptionspigment durch die Lasereinwirkung ausgeblichen/ oxidiert oder verdrängt wird.

Bei der Verwendung eines Effektpigments mit Sparkling-Effekt wie die Xirallic® -Typen werden zudem die Sparkling Intensity Si und Sparkling Area $S_a$ ebenfalls erhöht. Insbesondere zeigt sich eine stärker wachsende positive Differenz je flacher der Beobachtungswinkel wird. Das heißt, es kommen im gelaserten Bereich auch die Effektpigmente zu Reflexion, die nicht planparallel zur Schichtoberfläche liegen, aber durch die Lasereinwirkung freigelegt werden.

In Tabelle 1 sind die Differenzwerte $\Delta L$, $\Delta S_i$ und $\Delta S_a$ für gelaserte Beschichtungsbereiche im Vergleich zu den ungelaserten Bereichen mit den Effektpigmenten Xirallic® Crystal Silver und Xirallic® Micro Silver für verschiedene Beobachtungswinkel zusammengefasst.

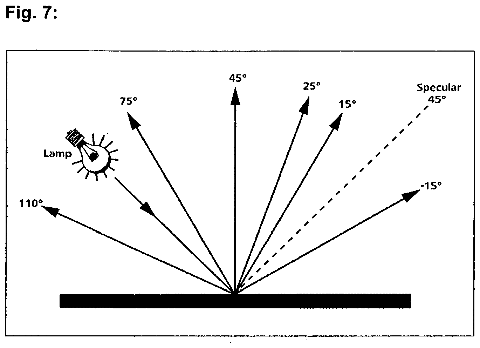

Der Einstrahlwinkel beträgt 45°. Die Angaben zum Beobachtungswinkel beziehen sich auf die Differenz zum Glanzwinkel (Abb. 7).

Tabelle 1: Differenzmesswerte der L-Werte, Sparkling Intensity Si und Sparkling Area $S_a$, ermittelt mit BykMac-Messgerät

$$(\Delta L = L_{gelasert} - L_{ungelasert}, \ \Delta S_i = S_{i\ gelasert} - S_{i\ ungelasert}, \ \Delta S_a = S_{a\ gelasert} - S_{a\ ungelasert})$$

| Pigment/ Beobachtungswinkel | $\Delta L$ | | | $\Delta S_i$ | | | $\Delta S_a$ | | |
|---|---|---|---|---|---|---|---|---|---|
| | 15° | 45° | 110° | 15° | 45° | 75° | 15° | 45° | 75° |
| Xirallic® Crystal Silver | 8,15 | 11,82 | 10,22 | 6,22 | 36,50 | 43,57 | -0,04 | 4,29 | 13,52 |
| Xirallic® Micro Silver | 6,03 | 8,32 | 5,41 | 1,92 | 12,82 | 20,21 | -0,79 | 2,57 | 14,25 |

**Abbildungen**

**Fig. 1** zeigt einen gelaserten Schriftzug in einer Beschichtung, die das Effektpigment Xirallic® Crystal Silver enthält (Belichtungswinkel: 75°, Beobachtungswinkel: 0°).

**Fig. 2** zeigt einen gelaserten Schriftzug in einer Beschichtung, die das Effektpigment Xirallic® Crystal Silver enthält (Belichtungswinkel: 45°, Beobachtungswinkel: 0°).

**Fig. 3** zeigt einen gelaserten Schriftzug in einer Beschichtung, die das Effektpigment Xirallic® Crystal Silver enthält (Aufnahme im Sonnenlicht).

**Fig. 4** zeigt ein gelasertes Bild in einer Beschichtung, die das Effektpigment Xirallic® Crystal Silver enthält.

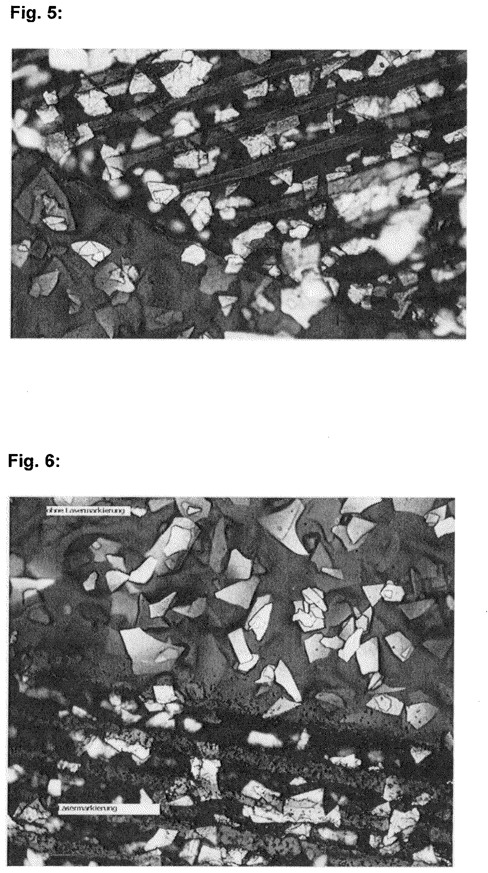

**Fig. 5** zeigt eine Mikroskopieaufnahme des Übergangs vom gelaserten Bereich (oben rechts) zum ungelaserten Bereich (unten links) mit völligem Ausbleichen des Rußes.

**Fig. 6** zeigt eine Mikroskopieaufnahme des Übergangs vom gelaserten Bereich (untere Bildhälfte) zum ungelaserten Bereich (obere Bildhälfte) mit Verdrängung des Rußes aus den gelaserten Streifen in die Randbereiche.

**Fig. 7** zeigt die Messgeometrie am BykMac-Gerät zur Ermittlung der $\Delta L$-, $\Delta S_i$-, $\Delta S_a$-Werte.

**Patentansprüche**

1. Verfahren zur Änderung der optischen Eigenschaften einer Effektpigment-haltigen Beschichtung umfassend das Bestrahlen einer Beschichtung (A) enthaltenden mindestens ein Effektpigment, mindestens ein Bindemittel und mindestens eine IR-Strahlung absorbierende Komponente mit einem IR-Laser, wobei durch die Einwirkung der Laserstrahlung die IR-Strahlung absorbierende Komponente teilweise oder vollständig aus den bestrahlten Bereichen der Beschichtung (A) entfernt wird und das Effektpigment in den bestrahlten Bereichen teilweise oder vollständig freigelegt wird und das Effektpigment ein Perlglanzpigment, ein Interferenzpigment, ein Metalleffektpigment und/oder ein Flüssigkristallpigment ist.

2. Verfahren nach Anspruch 1, **dadurch gekennzeichnet, dass** durch die Einwirkung der Laserstrahlung die IR-Strahlung absorbierende Komponente teilweise oder vollständig aus den bestrahlten Bereichen der Beschichtung (A) verdrängt, oxidiert und/oder ausgebleicht wird und das Effektpigment in den bestrahlten Bereichen teilweise oder vollständig freigelegt wird.

3. Verfahren nach einem oder mehreren der Ansprüche 1 bis 2, **dadurch gekennzeichnet, dass** die Beschichtung (A) mindestens ein Perlglanzpigment und/oder ein Interferenzpigment enthält.

4. Verfahren nach einem oder mehreren der Ansprüche 1 bis 3, **dadurch gekennzeichnet, dass** das Bestrahlen bildmäßig erfolgt und, bevorzugt dreidimensionale, Muster erzeugt werden.

5. Verfahren nach einem oder mehreren der Ansprüche 1 bis 4, **dadurch gekennzeichnet, dass** es die folgenden Schritte umfasst

   a) Aufbringen einer Beschichtung (A) enthaltend mindestens ein Effektpigment, mindestens ein Bindemittel und mindestens eine IR-Strahlung absorbierende Komponente auf ein Substrat, wobei das Effektpigment ein Perlglanzpigment, ein Interferenzpigment, ein Metalleffektpigment und/oder ein Flüssigkristallpigment ist, und ggf. Verfestigen der Beschichtung (A),
   b) Bestrahlen der in Schritt (a) aufgebrachten Beschichtung (A) mit einem IR-Laser,
   c) ggf. Aufbringen einer Schutzschicht (B) auf der gemäß Schritt b) behandelten Beschichtung (A).

6. Verfahren nach einem oder mehreren der Ansprüche 1 bis 5, **dadurch gekennzeichnet, dass** die Beschichtung (A) und die Schutzschicht (B) gleichzeitig verfestigt werden.

7. Verfahren nach einem oder mehreren der Ansprüche 1 bis 6, **dadurch gekennzeichnet, dass** als IR-Strahlung absorbierende Komponente Farbruße und/oder Phthalocyanine verwendet werden.

8. Beschichtung auf einem Substrat enthaltend ein optisch sichtbares Muster, wobei die Beschichtung mindestens ein Effektpigment, mindestens ein Bindemittel und mindestens eine IR-Strahlung absorbierende Komponente enthält, und die IR-Strahlung absorbierende Komponente in Teilbereichen des optischen Musters nicht vorhanden ist, und das Effektpigment in den bestrahlten Bereichen teilweise oder vollständig freigelegt ist, wobei das Effektpigment ein Perlglanzpigment, ein Interferenzpigment, ein Metalleffektpigment und/oder ein Flüssigkristallpigment ist.

9. Beschichtung nach Anspruch 8, **dadurch gekennzeichnet, dass** die IR-Strahlung absorbierende Komponente in Teilbereichen des optischen Musters teilweise oder vollständig verdrängt, oxidiert und/oder ausgebleicht ist.

10. Beschichtung nach einem oder mehreren der Ansprüche 8 bis 9, **dadurch gekennzeichnet, dass** das optische Muster taktil nicht erfassbar ist.

11. Beschichtung nach einem oder mehreren der Ansprüche 8 bis 10, **dadurch gekennzeichnet, dass** das optisch sichtbare Muster durch ein Verfahren gemäß einem oder mehreren der Ansprüche 1 bis 7 erhältlich ist.

12. Beschichtung nach einem oder mehreren der Ansprüche 8 bis 11, **dadurch gekennzeichnet, dass** es sich bei dem Substrat um ein Papier, eine Kartonage, eine Tapete, ein Laminat, ein Tissue-Material, Holz, ein Polymer, insbesondere eine polymere Folie, ein Metall, insbesondere eine Metallfolie, ein Sicherheitsdruckerzeugnis oder ein Material handelt, welches Bestandteile aus mehreren dieser Stoffe enthält, und wobei das Substrat optional elektrostatisch vorbehandelt und/oder mit einer Primerschicht und/oder einer anderen Grundierschicht versehen ist.

13. Verwendung einer Beschichtung nach einem oder mehreren der Ansprüche 8 bis 12 als Dekorationselement, als Funktionselement oder als Sicherheitsmerkmal auf einem Produkt.

14. Produkt, welches eine Oberfläche aufweist, die eine Beschichtung nach einem oder mehreren der Ansprüche 8 bis 12 aufweist.

15. Produkt, welches eine Oberfläche aufweist, die ein gemäß einem Verfahren nach einem oder mehreren der Ansprüche 1 bis 7 erzeugtes Muster in einer Beschichtung auf einem Substrat aus Papier, einer Kartonage, einer Tapete, einem Laminat, einem Tissue-Material, Holz, einem Metall, insbesondere einer Metallfolie, einem Polymer, insbesondere einer polymeren Folie, einem Sicherheitsdruckerzeugnis oder aus einem Material aufweist, welches Bestandteile aus mehreren dieser Stoffe enthält, und wobei das Substrat optional elektrostatisch vorbehandelt und/oder mit einer Primerschicht und/oder einer anderen Grundierschicht versehen ist und wobei die Beschichtung mindestens ein Effektpigment, mindestens ein Bindemittel und mindestens eine IR-Strahlung absorbierende Komponente enthält und in Teilbereichen des optischen Musters die IR-Strahlung absorbierende Komponente nicht vorhanden ist und das Effektpigment teilweise oder vollständig freigelegt ist, wobei das Effektpigment ein Perlglanzpigment, ein Interferenzpigment, ein Metalleffektpigment und/oder ein Flüssigkristallpigment ist.

16. Verwendung eines Produktes gemäß Anspruch 14 oder 15 als Dekorationsmaterial oder Sicherheitserzeugnis.

## Claims

1. Process for modifying the optical properties of an effect pigment-containing coating, comprising the irradiation of a coating (A) comprising at least one effect pigment, at least one binder and at least one IR radiation-absorbing component using an IR laser, where the action of the laser radiation partly or completely removes the IR radiation-absorbing component from the irradiated areas of the coating (A) and partly or completely uncovers the effect pigment in the irradiated areas, and the effect pigment is a pearlescent pigment, an interference pigment, a metal-effect pigment and/or a liquid-crystal pigment.

2. Process according to Claim 1, **characterised in that** the action of the laser radiation partly or completely displaces, oxidises and/or bleaches the IR radiation-absorbing component from the irradiated areas of the coating (A) and partly or completely uncovers the effect pigment in the irradiated areas.

3. Process according to one or more of Claims 1 to 2, **characterised in that** the coating (A) comprises at least one pearlescent pigment and/or interference pigment.

4. Process according to one or more of Claims 1 to 3, **characterised in that** the irradiation is carried out imagewise and patterns, preferably three-dimensional, are produced.

5. Process according to one or more of Claims 1 to 4, **characterised in that** it comprises the following steps:

a) application of a coating (A) comprising at least one effect pigment, at least one binder and at least one IR radiation-absorbing component to a substrate, where the effect pigment is a pearlescent pigment, an interference pigment, a metal-effect pigment and/or a liquid-crystal pigment, and optionally solidification of the coating (A),

b) irradiation of the coating (A) applied in step a) using an IR laser,

c) optionally application of a protecting layer (B) to the coating (A) treated in step b).

6.  Process according to one or more of Claims 1 to 5, **characterised in that** the coating (A) and the protecting layer (B) are solidified simultaneously.

7.  Process according to one or more of Claims 1 to 6, **characterised in that** the IR radiation-absorbing component used is colour blacks and/or phthalocyanines.

8.  Coating on a substrate comprising an optically visible pattern, where the coating comprises at least one effect pigment, at least one binder and at least one IR radiation-absorbing component, and the IR radiation-absorbing component is not present in part-areas of the optical pattern, and the effect pigment has been partly or completely uncovered in the irradiated areas, where the effect pigment is a pearlescent pigment, an interference pigment, a metal-effect pigment and/or a liquid-crystal pigment.

9.  Coating according to Claim 8, **characterised in that** the IR radiation-absorbing component has been partly or completely displaced, oxidised and/or bleached in part-areas of the optical pattern.

10. Coating according to one or more of Claims 8 to 9, **characterised in that** the optical pattern is not tactile.

11. Coating according to one or more of Claims 8 to 10, **characterised in that** the optically visible pattern is obtainable by a process according to one or more of Claims 1 to 7.

12. Coating according to one or more of Claims 8 to 11, **characterised in that** the substrate is a paper, a cardboard, a wallpaper, a laminate, a tissue material, wood, a polymer, in particular a polymeric film, a metal, in particular a metal foil, a security printing product or a material which comprises constituents of a plurality of these substances, and where the substrate has optionally been electrostatically pretreated and/or provided with a primer layer and/or another anchoring layer.

13. Use of a coating according to one or more of Claims 8 to 12 as decoration element, as functional element or as security feature on a product.

14. Product which has a surface which has a coating according to one or more of Claims 8 to 12.

15. Product which has a surface which has a pattern, produced by a process according to one or more of Claims 1 to 7, in a coating on a substrate comprising paper, a cardboard, a wallpaper, a laminate, a tissue material, wood, a metal, in particular a metal foil, a polymer, in particular a polymeric film, a security printing product or a material which comprises constituents of a plurality of these substances, and where the substrate has optionally been electrostatically pretreated and/or provided with a primer layer and/or another anchoring layer and where the coating comprises at least one effect pigment, at least one binder and at least one IR radiation-absorbing component and the IR radiation-absorbing component is not present and the effect pigment has been partly or completely uncovered in part-areas of the optical pattern, where the effect pigment is a pearlescent pigment, an interference pigment, a metal-effect pigment and/or a liquid-crystal pigment.

16. Use of a product according to Claim 14 or 15 as decoration material or security product.

**Revendications**

1.  Procédé pour modifier les propriétés optiques d'un revêtement contenant des pigments d'effet, comprenant l'irradiation d'un revêtement (A) comprenant au moins un pigment d'effet, au moins un liant et au moins un composant absorbant le rayonnement IR en utilisant un laser IR, où l'action du rayonnement du laser enlève partiellement ou complètement le composant absorbant le rayonnement IR au niveau des zones irradiées du revêtement (A) et découvre partiellement ou complètement le pigment d'effet dans les zones irradiées, et le pigment d'effet est un pigment nacré, un pigment d'interférence, un pigment à effet métallique et/ou un pigment à cristaux liquides.

**2.** Procédé selon la revendication 1, **caractérisé en ce que** l'action du rayonnement déplace partiellement ou complètement, oxyde partiellement ou complètement et/ou décolore partiellement ou complètement le composant absorbant le rayonnement IR au niveau des zones irradiées du revêtement (A) et découvre partiellement ou complètement le pigment d'effet dans les zones irradiées.

**3.** Procédé selon une ou plusieurs des revendications 1 à 2, **caractérisé en ce que** le revêtement (A) comprend au moins un pigment nacré et/ou un pigment d'interférence.

**4.** Procédé selon une ou plusieurs des revendications 1 à 3, **caractérisé en ce que** l'irradiation est mise en oeuvre image par image, et des motifs, de façon préférable tridimensionnels, sont produits.

**5.** Procédé selon une ou plusieurs des revendications 1 à 4, **caractérisé en ce qu'**il comprend les étapes qui suivent :

a) application d'un revêtement (A) comprenant au moins un pigment d'effet, au moins un liant et au moins un composant absorbant le rayonnement IR sur un substrat, où le pigment d'effet est un pigment nacré, un pigment d'interférence, un pigment à effet métallique et/ou un pigment à cristaux liquides, et en option, solidification du revêtement (A),
b) irradiation du revêtement (A) appliqué au niveau de l'étape a) en utilisant un laser IR,
c) en option, application d'une couche de protection (B) sur le revêtement (A) traité au niveau de l'étape b).

**6.** Procédé selon une ou plusieurs des revendications 1 à 5, **caractérisé en ce que** le revêtement (A) et la couche de protection (B) sont solidifiés simultanément.

**7.** Procédé selon une ou plusieurs des revendications 1 à 6, **caractérisé en ce que** le composant absorbant le rayonnement IR utilisé est constitué par des éléments de couleur noire et/ou des phtalocyanines à pouvoir tinctorial.

**8.** Revêtement sur un substrat comprenant un motif optiquement visible, où le revêtement comprend au moins un pigment d'effet, au moins un liant et au moins un composant absorbant le rayonnement IR, et le composant absorbant le rayonnement IR n'est pas présent dans des zones partielles du motif optique, et le pigment d'effet a été partiellement ou complètement découvert dans les zones irradiées, où le pigment d'effet est un pigment nacré, un pigment d'interférence, un pigment à effet métallique et/ou un pigment à cristaux liquides.

**9.** Revêtement selon la revendication 8, **caractérisé en ce que** le composant absorbant le rayonnement IR a été partiellement ou complètement déplacé, oxydé et/ou décoloré dans des zones partielles du motif optique.

**10.** Revêtement selon une ou plusieurs des revendications 8 à 9, **caractérisé en ce que** le motif optique n'est pas tactile.

**11.** Revêtement selon une ou plusieurs des revendications 8 à 10, **caractérisé en ce que** le motif optiquement visible peut être obtenu au moyen du procédé selon une ou plusieurs des revendications 1 à 7.

**12.** Revêtement selon une ou plusieurs des revendications 8 à 11, **caractérisé en ce que** le substrat est un papier, un carton, un papier peint, un stratifié, un matériau de tissu, du bois, un polymère, en particulier, un film polymérique, un métal, en particulier, une feuille métallique, un produit à impression de sécurité ou un matériau qui comprend des constituants d'une pluralité de ces substances, et où le substrat a, en option, été prétraité électrostatiquement et/ou muni d'une couche d'amorçage et/ou d'une autre couche d'ancrage.

**13.** Utilisation d'un revêtement selon une ou plusieurs des revendications 8 à 12 en tant qu'élément de décoration, en tant qu'élément fonctionnel, ou en tant que caractéristique de sécurité sur un produit.

**14.** Produit qui comporte une surface qui comporte un revêtement selon une ou plusieurs des revendications 8 à 12.

**15.** Produit qui comporte une surface qui comporte un motif, produit au moyen d'un procédé selon une ou plusieurs des revendications 1 à 7, dans un revêtement sur un substrat comprenant du papier, un carton, un papier peint, un stratifié, un matériau de tissu, du bois, un métal, en particulier, une feuille métallique, un polymère, en particulier, un film polymérique, un produit à impression de sécurité ou un matériau qui comprend des constituants d'une pluralité de ces substances, et où le substrat a, en option, été prétraité électrostatiquement et/ou muni d'une couche d'amorçage et/ou d'une autre couche d'ancrage et où le revêtement comprend au moins un pigment d'effet, au moins un liant, et le composant absorbant le rayonnement IR n'est pas présent et le pigment d'effet a été partiellement ou complètement découvert dans des zones partielles du motif optique, où le pigment d'effet est un pigment nacré, un pigment d'interférence, un pigment à effet métallique et/ou un pigment à cristaux liquides.

16. Utilisation d'un produit selon la revendication 14 ou 15 en tant que matériau de décoration ou produit de sécurité.

**Fig. 1:**

Beobachtung: 0°, Belichtung: 75°

**Fig. 2:**

Beobachtung: 0°, Belichtung: 45°

Fig. 3:

Fig. 4:

**Fig. 5:**

**Fig. 6:**

## Fig. 7:

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1215233 B
- WO 2011107271 A
- WO 2004045857 A
- US 4675212 A
- GB 2272848 A
- US 7047883 B
- EP 428933 B1
- WO 2012079674 A

**In der Beschreibung aufgeführte Nicht-Patentliteratur**

- **T. SCHAUER ; R. MAURER ; H. GREISIGER.** *Kunstoffe,* 2008, vol. 9, 102-107
- Das objektive Auge. *BYK-Gardner Digital Katalog,* 2013, 97